# EUROPÄISCHE PATENTSCHRIFT

(11) **EP 1 774 056 B1**
(45) Veröffentlichungstag und Bekanntmachung des Hinweises auf die Patenterteilung: **18.05.2011**
(21) Anmeldenummer: 05716765.2
(22) Anmeldetag: 22.02.2005
(51) Int. Cl.: C23C 16/30, C30B 29/52

(54) **VERFAHREN ZUR ABSCHEIDUNG VON SILIZIUM UND GERMANIUM ENTHALTENDEN SCHICHTEN**
METHOD FOR THE DEPOSITION OF LAYERS CONTAINING SILICON AND GERMANIUM
PROCEDE DE DEPOT DE COUCHES CONTENANT DU SILICIUM ET DU GERMANIUM

(30) Priorität: 15.07.2004 DE 102004034103
(43) Veröffentlichungstag der Anmeldung: 18.04.2007
(73) Patentinhaber: Aixtron SE, 52134 Herzogenrath (DE)
(72) Erfinder: SCHUMACHER, Marcus, 5017 Kerpen-Blatzheim (DE); BAUMANN, Peter, 52072 Aachen (DE); LINDNER, Johannes, 52159 Roetgen (DE); MCENTEE, Timothy, 52134 Herzogenrath (DE)
(74) Vertreter: Grundmann, Dirk
(86) Internationale Anmeldenummer: PCT/EP2005/050756
(87) Internationale Veröffentlichungsnummer: WO 2006/005637

(56) Entgegenhaltungen:
- EP-A- 0 307 995
- EP-A- 1 039 512
- WO-A-01/66832
- WO-A-03/103031
- DE-A1- 10 057 491
- DE-A1- 10 114 956
- DE-A1- 10 156 932
- HIROYUKI HIRAYAMA ET AL: "SELECTIVE HETEROEPITAXIAL GROWTH OF SI1-XGEX USING GAS SOURCE MOLECULAR BEAM EPITAXY" APPLIED PHYSICS LETTERS, AMERICAN INSTITUTE OF PHYSICS. NEW YORK, US, Bd. 56, Nr. 12, 19. März 1990 (1990-03-19), Seiten 1107-1109, XP000133462 ISSN: 0003-6951
- NAKAI K ET AL: "LOW-TEMPERATURE HETEROEPITAXIAL GROWTH OF SIGE ON SI WITH LOW-PRESSURE CHEMICAL VAPOR DEPOSITION" JOURNAL OF CRYSTAL GROWTH, NORTH-HOLLAND, AMSTERDAM, NL, Bd. 126, Nr. 2/3, 2. Januar 1993 (1993-01-02), Seiten 285-292, XP000364254 ISSN: 0022-0248

## Beschreibung

Die Erfindung betrifft ein Verfahren zum Abscheiden von Silizium und Germanium enthaltenen Schichten.

Zur Abscheidung von metalloxidischen Schichten wie Hafniumoxid, Aluminiumoxid, oder auch Praseodymoxid werden in der Literatur Verfahren wie, Molecular Beam Epitaxy (MBE), Organic Chemical Vapor Deposition (MOCVD) und Atomic Layer Deposition (ALD) aufgeführt.

MBE hat den Nachteil, dass die Schichten oft keine ausreichende Qualität für Device-Anwendungen besitzen, insbesondere bei SiGe:C. Bei UHV-CVD kann mit tiefen Drücken ein hinreichend geringer Verunreinigungshintergrund erreicht werden. Dies ist aber von der Vakuumtechnik her aufwendig und bringt geringere Wachstumsraten mit sich. Insbesondere für Ge-reiche Heterostrukturen gibt es Nachteile durch geringe Wachstumsraten und hohe Oberflächenrauhigkeit. Andere CVD-Methoden verwenden Prozessdrücke in der Größenordnung von 1-100 mbar und erreichen eine vergleichbare Reduktion von Verunreinigungen durch hohe Spülflüsse mit hochreinen Gasen. Oft werden Si- und Ge-haltige Gase als Ausgangssubstanzen verwendet. Diese Gase sind sicherheitstechnisch problematisch und schwierig zu handhaben. Dies bringt ein entsprechend hohes Gefahrenpotential und die Notwendigkeit von aufwendigen sicherheitstechnischen Maßnahmen mit sich. Viele dieser Prozesse finden bei hohen Temperaturen statt, was die Herstellung von verspannten Schichten erschwert.

Einige flüssige Ausgangssubstanzen (Precursoren) bieten Vorteile bei der Abscheidung bei tiefen Temperaturen und können so neue Perspektiven bei der Produktion insbesondere von verspannten Schichten ermöglichen. Die Verwendung von flüssigen Ausgangssubstanzen (Precursoren) ist bisher schwierig. Allgemein wird die konventionelle Verdampfung flüssiger Ausgangssubstanzen mit beheizten Behältern (Bubblern) durchgeführt. Dabei werden die Ausgangssubstanzen mittels eines Trägergases in die Gasphase transferiert. Das ständige Beheizen der Precursoren führt oft zu nicht reproduzierbaren Abscheidungsbedingungen. Weiterhin läßt sich eine vollständige Sättigung der Gasphase und damit hohe Wachstumsraten über solche Anordnungen nur schwer erzielen. Für CVD wurden daher verschiedene Flüssig-Precursor-Zuführungs-Systeme entwickelt, die auf abrupter Verdampfung kleiner Precursormengen durch direkten Kontakt mit beheizten Oberflächen beruhen. Dies zieht Nachteile mit sich wie zeitlich verändertes Verdampfungsverhalten durch Ablagerungen auf den beheizten Oberflächen und Partikelbildung. Durch periodische Injektion von Flüssigprecursoren in ein geheiztes Volumen mit anschließender kontaktfreien Verdampfung könnten diese Nachteile vermieden werden. Bei konventioneller CVD ergeben sich auf Grund der schlechten atomaren Präzision Unzulänglichkeiten hinsichtlich der chemischen Zusammensetzung und der Schichtendickenkontrolle z. B. bei der Abscheidung von sehr dünnen SiGe-Bufferschichten, die eine räumlich graduierte chemische Zusammensetzung aufweisen.

Konventionelle MOCVD-Verfahren, die auf flüssigen oder festen Precursoren beruhen, verwenden beheizte Precursor-Behälter zur Überführung von flüssigen Precursoren mittels eines Trägergases in die Gasphase. Die meisten Precursoren (bzw. entsprechende verdünnte Lösungen) sind meist schwer flüchtig und chemisch wie thermisch instabil und verändern bzw. zersetzen sich unter solchen Bedingungen, was die Abscheidung nicht reproduzierbar macht. Daher wurden für MOCVD verschiedene Flüssig-Precursor-Zuführungssysteme entwickelt, die auf abrupter Verdampfung jeweils kleiner Precursormengen durch direkten Kontakt mit beheizten Oberflächen beruhen. Dies zieht Nachteile mit sich wie zeitlich verändertes Verdampfungsverhalten durch Ablagerungen auf den beheizten Oberflächen und Partikelbildung. Durch periodische Injektion von Flüssigkeitsprecursoren oder Lösungen in ein geheiztes Volumen mit anschließender kontaktfreier Verdampfung können diese Nachteile vermieden werden. Bei konventioneller MOCVD ergeben sich aufgrund der schlechten atomaren Präzision Probleme z.B. bei der Abscheidung von Nanolaminaten.

Um die Weiterentwicklung elektronischer Bauteile für CMOS-Anwendungen zu gewährleisten, ist eine Ergänzung der Silizium-Technologie erforderlich. SiGe ermöglicht höhere Geschwindigkeit bei gleichzeitig geringerem Energieverbrauch. Dies wird bereits in der heutigen Technologie verwendet und ist für zukünftige Technologiegenerationen von weitreichender Bedeutung. Durch die Verwendung von SiGe in z.B. HBT's kann Silizium-Technologie im Hochfrequenzbereich erfolgreich mit III/V (z. B. GaAs) basierten Strukturen konkurrieren. SiGe hat den Vorteil, dass es mit Standard Silizium Prozesstechnologie kompatibel ist und kostengünstiger als entsprechende III/V Strukturen produziert werden kann. Oft werden HBT's mit BiCMOS-Strukturen integriert. Bei SiGe kann durch die Veränderung des Si/Ge Verhältnisses die Energie Bandlücke maßgeschneidert werden. Bei HBT's ist die Bandlücke der Basis geringer als die des Emitters. Dadurch wird sowohl der Rückfluss von Ladungsträgern verhindert und die Emitter-Injektions-Frequenz erhöht als auch eine sehr hohe Dotierung der Basis und damit eine höhere Frequenz ermöglicht. Durch die unterschiedlichen Gitterkonstanten von Si und Ge lassen sich verspannte Gitter herstellen, die höhere Beweglichkeit der Elektronen und Löcher erlauben und damit entsprechende Leistungssteigerungen ermöglichen. Um eine solche Verspannung zu gewährleisten, muss die SiGe Abscheidung bei relativ tiefen Temperaturen stattfinden. Mit Hilfe von Kohlenstoff-Dotierung können die Eigenschaften weiter stabilisiert bzw. verbessert werden, indem das Ausdiffundieren von Bor-Dotierungen verhindert wird und somit aggressivere und leistungsfähigere Schicht-Strukturen entwickelt werden können. Um verspannte Schichten in hoher Device-Qualität herzustellen sind oft SiGe Buffer-Schichten mit räumlich graduierter chemischer Zusammensetzung notwendig. Bei zunehmender Miniaturisierung in den nächsten Technologiegenerationen müssen diese Bufferschichten auch immer dünner werden. Dies erfordert eine Abscheidungstechnologie mit hoher Präzision und Flexibilität.

Die Erfindung betrifft ein Verfahren zum Abscheiden mindestens einer Halbleiterschicht auf mindestens einem Substrat in einer Prozesskammer, wobei die Halbleiterschicht aus mehreren Komponenten besteht und die Komponenten mittels nicht kontinuierlicher Injektion eines flüssigen oder in einer Flüssigkeit gelösten Ausgangsstoffes mittels je einer Injektoreinheit in eine temperierte Verdampfungskammer verdampft wird und dieser Dampf mittels eines Trägergases der Prozesskammer zugeführt wird.

Ein derartiges Verfahren bzw. eine derartige Vorrichtung ist aus der DE 100 57 491 vorbekannt. Diese Vorrichtung dient der Verdampfung flüssiger oder einer auf eine Flüssigkeit gelöster Ausgangsstoffe. Mit der Injektoreinheit wird ein Aerosol erzeugt. Die Tröpfchen des Aerosols verdampfen in der Verdampfungskammer, wobei dem sich darin befindlichen Gas die erforderliche Wärme entzogen wird. Die Verdampfung erfolgt somit ohne Oberflächenkontakt. Als Ausgangsstoffe kommen solche Verbindungen in Betracht, wie sie von der DE 10156 932 A1 und der DE 10114 956 A1 beschrieben werden. Bei dem Verfahren von EP-A-1 039 512 werden Ausgangsstoffe in Form von Pulsen direkt in eine Reaktorkammer eingebracht. WO 2005/026401 wird unter Actikel 54(3) EPÜ als Stand der Technik bewertet.

Der Erfindung liegt die Aufgabe zugrunde, ein leistungsfähiges Verfahren gemäß Anspruch 1 anzugeben, mit welchem sich Silizium-/Germaniumschichten abscheiden lassen.

Gelöst wird die Aufgabe durch die in den Ansprüchen angegebene Erfindung. Der Anspruch 1 zielt im wesentlichen darauf ab, dass ein erster Ausgangsstoff Silizium enthält und ein zweiter Ausgangsstoff Germanium. Ferner ist vorgesehen, dass die den zeitlichen Verlauf des Massenflusses durch jede Injektoreinheit bestimmenden Massenflußparameter, wie der Injektionsvordruck, die Injektionsfrequenz und das Puls/Pausenverhältnis sowie die Phasenbeziehung der Puls/Pausen zu den Puls/Pausen der anderen Injektoreinheit(en) individuell eingestellt oder variiert werden.

Die Erfindung stellt ein Verfahren unter Verwendung von nicht kontinuierlicher Injektion von einer oder mehreren flüssigen Ausgangssubstanzen, die Si, Ge und/oder C enthalten, in mindestens ein geheiztes Volumen mit anschließender Überführung in die Gasphase dar. Dieses wird zur Herstellung von SiGe, strained SiGe, oder SiGe:C Schichten benutzt. Dieses Verfahren ermöglicht nicht nur das kontaktfreie Verdampfen von den Quellenmaterialien und damit die reproduzierbare und partikelfreie Abscheidung von Schichten, sondern auch die genaue Kontrolle von Si, Ge, und C-Dotierungs Anteilen während der Schichtformierung über zusätzliche Flüssig-Precursor-Injektionseinheiten, welche unabhängig voneinander in Injektionsrate bzw. Puls/Pausenverhältnis aber auch Phasenbeziehung zueinander einstellbar sind. Dieses Verfahren ermöglicht folglich die Formierung von Gradienten-Schichten über die Änderung der zugegebenen Einzelmengen von Ausgangssubstanzen. Dieses wird in technischer Realisierung durch Änderung der jeweiligen Injektionsfrequenz, Puls/Pausenverhältnis aber auch Injektionsvordruckänderungen geregelt. Bei der Formierung, z. B. von verspanntem Si auf einer Si-Oberfläche sind die Vorteile des entwickelten Verfahrens offensichtlich, da der gesamte Stapel von graduierter SiGe-Bufferschicht, entspannter SiGe-Schicht und verspannter Si-Schicht in einer Prozessierungssequenz durch Insituänderung der Gasphasenkomposition bzw. Prozessbedingungen möglich wird. Vorteile dieses neuen Verfahren sind daher hoher Durchsatz, gute stoichiometrische Kontrolle, große Flexibilität an Prozessbedingungen, atomar präzise Abscheidung, Herstellung von Nanolaminaten und Hyperstrukturen, kontrollierte Abscheidung von Nukleationslagen sowie Gradienten-Schichten. Insbesondere in Kombination dieser nicht-kontinuierlichen Injektion mit einem Gasverteiler lassen sich die in die Prozesskammer zugeführten gasförmigen Ausgangssubstanzen homogen über große Substratoberflächen verteilen. Dies ermöglicht eine hohe Homogenität bei der Abscheidung bei gleichzeitig hoher Flexibilität im Prozessfenster. Bei der Prozesskammer handelt es sich vorzugsweise um eine Vakuumkammer. Der Druck kann dort weniger als 1000 mbar betragen. Die Prozesskammer kann geheizt werden. Während eines einzigen Prozessschrittes können mehrere Schichtfolgen auf dem Substrat abgeschieden werden. Die Abscheidung der Schichtenfolge erfolgt im wesentlichen durch ledigliche Variation der Massenflussparameter. Der Injektionsvordruck bzw. die Injektionsfrequenz oder das Puls/Pausenverhältnis kann so variiert werden, dass Schichten unterschiedlicher Qualität unmittelbar aufeinander abgeschieden werden, ohne das zwischen der Abscheidung der aufeinanderfolgenden Schichten eine Pause erfolgen muss. Ferner ist es mit dem erfindungsgemäßen Verfahren möglich, Gradientenstrukturen abzuscheiden. Dies erfolgt durch eine kontinuierliche Variation der Massenflussparameter während des Abscheidens mindestens einer Schicht. Hierdurch wird in der Vertikalen eine kontinuierlich sich ändernde Schichtzusammensetzung ausgebildet. Mit dieser Methode können auch kontinuierliche Übergänge zwischen zwei abgeschiedenen Schichten erzielt werden. Es ist von Vorteil, wenn die Massenflüsse der Ausgangsstoffe zu den Injektoreinheiten mittels Massenflussmessung ermittelt werden. Die Massenströme können durch Variation der Injektionsfrequenz, das Puls/Pausenverhältnisses und/oder des Injektionsvordruckes eingestellt werden. Als Ausgangsstoffe kommen insbesondere die Tetramethyle des Silizium und des Germaniums oder die Tetraethyle dieser Elemente in Betracht. Besonders bevorzugt sind die bei Raumtemperatur flüssigen Precursoren: Germaniumtetrachlorid, Siliziumtetrachlorid, Tetraethoxygerman, Tetraethoxysilan. Die Precursoren können in reiner Form verwendet werden. Es können aber auch organische Lösungsmittel verwendet werden. Als Ausgangsstoffe können neben Flüssigkeiten auch in einer Flüssigkeit gelöste Feststoffe verwendet werden. Die Schichten können auch Nitride enthalten. Der Substrathalter kann drehangetrieben sein. Jeder Injektoreinheit ist ein individueller Massenflussmesser zugeordnet. Mehrere Injektionseinheiten können einer Mehrkanalinjektionseinheit zugeordnet sein. Dann ist es von Vorteil, wenn jeder Mehrkanalinjektionseinheit eine individuelle Verdampfungskammer zugeordnet ist. Jede dieser Verdampfungskammern kann temperiert werden. Auch die Rohrleitungen zwischen den Verdampfungskammern und der Prozesskammer können temperiert sein. Innerhalb der Prozesskammer kann sich ein duschkopfförmiger Gasverteiler befinden. Dieser duschkopfförmige Gasverteiler befindet sich oberhalb des Substrates. Aus den an der Unterseite des Gasverteilers angeordneten Öffnungen strömt das Prozessgas in die Prozesskammer, um auf der Oberfläche des Substrates zu reagieren, wobei die Schicht gebildet wird. Die Vorrichtung weist eine elektronische Steuereinrichtung auf. Mit dieser elektronischen Steuereinrichtung werden die individuellen Massenflussparameter eingestellt und geregelt.

Das Verfahren dient der Abscheidung von SiGe-Schichten. Es handelt sich dabei auch um strained/unstrained (verspannte oder unverspannte) SiGe-Schichten. Diese Schichten können Kohlenstoff enthalten. Das Verfahren erlaubt eine genaue Einstellung der Schichtkomposition und der Formierung von Gradienten-Schichten durch Insitumassenflußregelungen der Einzelquellen bei atomarer Kontrolle von chemischer Zusammensetzung und Schichtdicke ohne die Prozesssequenz zu unterbrechen. So kann beispielsweise auf einem Siliziumsubstrat eine Übergangsschicht auf eine Germaniumoberfläche abgeschieden werden. Hierzu wird der Prozess dadurch begonnen, dass nur die Silizium enthaltende Komponente zugeführt wird. Der Zufluß dieser Komponente wird dann kontinuierlich vermindert. Einhergehend damit wird der Zufluß der Germanium enthaltenden Komponente kontinuierlich gesteigert, bis zum Schluß nur noch die germaniumhaltige Komponente injiziert wird. Hierdurch entsteht ein gitterangepaßter Übergang von einer Siliziumoberfläche zu einer Germaniumoberfläche.

Ein Ausführungsbeispiel der Erfindung wird nachfolgend anhand beigefügter Zeichnungen erläutert.

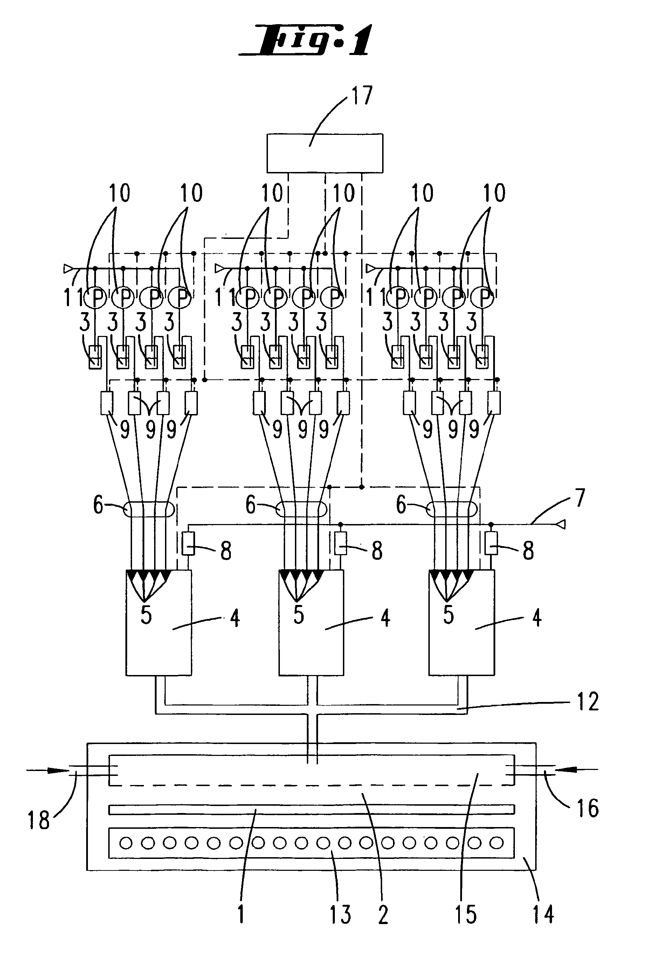

Die Fig.1 zeigt in schematischer Darstellung den Aufbau einer Vorrichtung zur Ausübung des Verfahrens.

Die Vorrichtung dient der Abscheidung von ein- und mehrkomponentigen Materialien unter Verwendung von nicht-kontinuierlicher Injektion von flüssigen oder gelösten Metall-Ausgangs-Substanzen über eine Mehrkanal-Injektoreinheit 6, wobei jeder Kanal 5 einzeln in Injektionsfrequenz, Injektorvordruck, Puls-Pausenverhältnis und Phasenbeziehung untereinander zur Massenflussregelung einstellbar ist. Diese Vorrichtung soll speziell für die Abscheidung von Silizium- und Germaniumschichten oder SiGe-Schichten auf einem Silizium- oder Germaniumsubstrat dienen.

Im Einzelnen besitzt die Vorrichtung einen Reaktor, der eine Reaktorkammer 14 ausbildet. Diese Reaktorkammer 14 ist mit nicht dargestellten Mitteln mit einer nicht dargestellten Vakuumeinrichtung verbunden. Innerhalb der Reaktorkammer befindet sich eine Heizung 13. Oberhalb der Heizung 13 ist das Substrat 1 angeordnet. Das Substrat 1 ist in der Figur 1 vergrößert dargestellt. In der Realität lagert es auf einem Substrathalter, welcher drehangetrieben werden kann. Oberhalb des Substrates 1 befindet sich die Prozesskammer 2, die nach oben von einem duschkopfartig ausgebildeten Gasverteiler 15 begrenzt wird.

In den Gasverteiler 15 mündet eine Zuleitung 12. Durch diese Zuleitung 12 können die verdampften Ausgangsstoffe 3 zusammen mit einem Trägergas 7 in den Gasverteiler 15 einleitet werden.

Die oben genannten Zuleitungen 12 können temperierte Rohrverbindungen sein. Diese verbinden Verdampfungskammern 4 mit dem Gasverteiler 15.

Bei dem dargestellten Ausführungsbeispiel sind insgesamt drei Verdampfungskammern 4 vorgesehen. Es können aber weniger oder mehr sein. Jede dieser Verdampfungskammern 4 besitzt eine Mehrkanalinjektionseinheit, die mit der Bezugsziffer 6 angedeutet sind. Jede Mehrkanalinjektionseinheit 6 besitzt eine Vielzahl, im Ausführungsbeispiel vier Injektionseinheiten 5. Es können aber auch mehr oder weniger sein. Mit der Injektionseinheit 5 kann jeweils eine flüssige oder in einer Flüssigkeit gelöste Ausgangssubstanz 3 als Aerosol in die Verdampfungskammer 4 injiziert werden. Jede Injektionseinheit 5 besitzt ein Austrittsventil, welches pulsierend öffnet und schließt. Die Pulsweiten können zwischen einigen Sekunden und wenigen Millisekunden variiert werden. Im gleichen Spektrum können auch die Pulsweiten variiert werden. Jede Injektoreinheit 5 wird individuell von einer Steuereinrichtung 17 angesteuert. Dabei können die Massenflussparameter Pulsweite, Pausenweite und Pulsfrequenz individuell gesteuert werden. Der Massenfluss durch jede Injektoreinheit 5 wird mittels eines Massenflussmessers 9 gemessen. Der ebenfalls individuell für jede Injektoreinheit 5 einstellbare Injektionsvordruck wird mittels eines Druckreglers 10 eingestellt. Mit dem Druck, der von dem Druckregler 10 eingestellt wird, wird ein Vorratsbehälter druckbeaufschlagt, in welchem sich der Ausgangsstoff befindet.

In jede der Verdampfungskammern 4 mündet eine Zuleitung für ein Trägergas 7. Der Massenfluss des Trägergases 7 wird mittels eines Massenflussreglers 8 eingestellt.

Als Ausgangsstoffe kommen insbesondere die metallorganischen Silizium und/oder die metallorganischen Germaniumverbindungen in Betracht. Diese Ausgangsverbindungen werden in Form von Pulsen in Form von mit einem inerten Trägergas, bei dem es sich um ein Edelgas, Wasserstoff oder Stickstoff handeln kann, in eine Verdampfungskammer 4 eingebracht. Das inerte Trägergas kann vorgeheizt sein. Bevorzugt ist aber die gesamte Verdampfungskammer vorgeheizt, so dass die für die Verdampfung erforderliche Energie unmittelbar aus dem sich in der Verdampfungskammer 4 befindlichen Gas entnommen werden kann. Die Verdampfung erfolgt deshalb ohne Oberflächenkontakt. Das erfindungsgemäße Verfahren läßt sich in besonderer Weise vorteilhaft anwenden, wenn hochflüchtige, flüssige oder feste Ausgangsstoffe zur Verfügung stehen. Feste Ausgangsstoffe können in geeigneten Lösungsmitteln gelöst werden, um dann zusammen mit den Lösungsmitteln in die Verdampfungskammer injiziert zu werden.

## Patentansprüche

1. Verfahren zum Abscheiden mindestens einer Silizium und Germanium enthaltenden Halbleiterschicht auf mindestens einem Substrat in einer Prozesskammer (2), wobei die Halbleiterschicht aus mehreren Komponenten besteht und die Komponenten mittels nicht kontinuierlicher Injektion eines flüssigen oder in einer Flüssigkeit gelösten Ausgangstoffes (3) mittels je einer Injektoreinheit (5) in eine temperierte Verdampfungskammer (4) eingebracht werden, in welchem die Ausgangsstoffe verdampfen, und dieser Dampf mittels eines Trägergases (7) der Prozesskammer zugeführt wird, wobei die den zeitlichen Verlauf des Massenflusses eines Silizium enthaltenen ersten Ausgangsstoffes und eines Germanium enthaltenen zweiten Ausgangsstoffes (3) durch die zugeordnete Injektoreinheit (5) bestimmenden MassenflussParameter, wie der Injektionsvordruck, die Injektionsfrequenz, das Puls/Pausenverhältrus sowie die Phasenbeziehung der Puls/Pausen zu den Pulsen/Pausen der anderen Injektoreinheit(en) individuell eingestellt oder variiert werden, wobei die verdampften Ausgangsstoffe zu mindestens einer Silizium-, Germanium- oder SiGe-Schicht auf einem Gruppe IV Substrat abgeschieden werden.

2. Verfahren nach Anspruch 1, **dadurch gekennzeichnet, dass** auf einer kristallinen Oberfläche epitaktisch mindestens eine Si-, SiGe- und/oder Ge-Schicht abgeschieden werden.

3. Verfahren nach einem der vorhergehenden Ansprüche, **dadurch gekennzeichnet, dass** das Substrat ein Si, SiGe oder Ge-Substrat ist.

4. Verfahren nach einem der vorhergehenden Ansprüche, **dadurch gekennzeichnet, dass** mindestens eine der folgenden Schichten abgeschieden werden: Si, Ge, SiGe, SiGe:C, Si/Ge Hyperstrukturen, SiGe/SiGe Hyperstrukturen, SiGe-Buffer, wobei "SiGe", unterschiedliche Schichten mit Si₁₋ₓGeₓ(0 = x =1) beinhaltet.

5. Verfahren nach einem der vorhergehenden Ansprüche, **dadurch gekennzeichnet, dass** die Ausgangsstoffe gleichzeitig oder alternierend injiziert werden.

6. Verfahren nach einem der vorhergehenden Ansprüche, **dadurch gekennzeichnet, dass** die in die Gasform gebrachten Ausgangsstoffe über einen Gasverteiler (15) homogen über die von den Substraten eingenommene Fläche verteilt werden.

7. Verfahren nach einem der vorhergehenden Ansprüche, **dadurch gekennzeichnet, dass** das oder die zu beschichtenden Substrate während des Abscheidungsprozesses gedreht werden.

8. Verfahren nach einem der vorhergehenden Ansprüche, **dadurch gekennzeichnet, dass** von den abgeschiedenen Schichten mindestens eine verspannt bzw. entspannt ist.

9. Verfahren nach einem der vorhergehenden Ansprüche, **dadurch gekennzeichnet dass** die chemische Zusammensetzung der Schicht in räumlicher Abhängigkeit verändert wird.

10. Verfahren nach einem der vorhergehenden Ansprüche, **gekennzeichnet durch** mindestens zwei unabhängig regelbare Injektoreinheiten zur parallelen Zuführung der Ausgangsstoffe zur Abscheidung verschiedenartiger Schichten.

11. Verfahren nach einem der vorhergehenden Ansprüche, **dadurch gekennzeichnet, dass** die zeitlich über mehrere Pulse gemittelten Massenflüsse der Germanium und Silizium enthaltenden Komponenten in die Prozesskammer derart kontinuierlich oder schrittweise geändert wird, dass das Massenverhältnis vom Silizium und Germanium in der auf dem Substrat abgeschiedenen Schicht über die Schichthöhe variiert.

## Claims

1. Process for depositing at least one semiconductor layer containing silicon and germanium on at least one substrate in a process chamber (2), the semiconductor layer comprising a plurality of components, and the components being introduced, into a temperature-controlled vaporization chamber (4) by means of discontinuous injection of a liquid starting material (3) or a starting material (3) dissolved in a liquid, by use of, in each case, an injector unit (5), the starting materials vaporizing in the vaporization chamber and this vapour being fed to the process chamber by means of a carrier gas (7), mass flow parameters determining the time profile of the mass flow of a first starting material, which contains silicon, and of a second starting material (3), which contains germanium, through the associated injector unit (5), these parameters being, for example, the injection feed pressure, the injection frequency, the pulse/pause ratio, as well as the phase relationship of the pulses/pauses with respect to the pulses/pauses of the other injector unit(s), being individually set or varied, the vaporized starting materials being deposited on a group IV substrate to form at least one silicon, germanium and/or SiGe layer.

2. Process according to Claim 1, **characterized in that** at least one Si, SiGe and/or Ge layer is deposited epitaxially on a crystalline surface.

3. Process according to either of the preceding claims, **characterized in that** the substrate is an Si, SiGe and/or Ge substrate.

4. Process according to any of the preceding claims, **characterized in that** at least one of the following layers is deposited: Si, Ge, SiGe, SiGe:C, Si/Ge hyperstructures, SiGe/SiGe hyperstructures, SiGe buffers, wherein "SiGe" encompasses various layers with Si₁₋ₓGeₓ(0 = x = 1).

5. Process according to any of the preceding claims, **characterized in that** the starting materials are injected simultaneously or alternately.

6. Process according to any of the preceding claims, **characterized in that** the starting materials, which have been converted into the gas form, are distributed homogeneously over the area taken up by the substrates using a gas distributor (15).

7. Process according to any of the preceding claims, **characterized in that** the substrate(s) to be coated are rotated during the deposition process.

8. Process according to any of the preceding claims, **characterized in that**, of the deposited layers, at least one is strained or unstrained.

9. Process according to any of the preceding claims, **characterized in that** the chemical composition of the layer is altered as a function of spatial parameters.

10. Process according to any of the preceding claims, **characterized by** at least two injector units, which can be controlled independently, for supplying the starting substances in parallel for deposition of layers of different types.

11. Process according to any of the preceding claims, **characterized in that** the mass flows of the components containing germanium and silicon into the process chamber, taken as an average over time of a plurality of pulses, are altered continuously or in steps, in such a manner that the mass ratio of silicon and germanium in the layer deposited on the substrate varies over the height of the layer.

## Revendications

1. Procédé de dépôt d'au moins une couche de semi-conducteurs contenant du silicium et du germanium sur au moins un substrat dans une chambre de réaction (2), la couche de semi-conducteurs étant constituée de plusieurs composants et les composants étant introduits dans une chambre de vaporisation (4), équilibrée en température, en injectant de façon discontinue une matière de départ (3), liquide ou dissoute dans un liquide, au moyen d'une unité d'injection (5), procédé dans lequel les matières de départ sont vaporisées et cette vapeur est amenée à la chambre de réaction au moyen d'un gaz de support (7), les paramètres de flux massique déterminant, par le biais de l'unité d'injection associée (5), l'allure dans le temps du flux massique d'une première matière de départ contenant du silicium et d'une seconde matière de départ (3) contenant du germanium, telle que la pression d'injection, la fréquence d'injection, l'intervalle d'impulsions ainsi que la relation de phase entre l'intervalle d'impulsions et l'intervalle d'impulsions de l'autre ou des autres unité(s) d'injection sont réglés ou modifiés individuellement, les matières de départ vaporisées sont déposées sur un substrat du groupe IV pour donner au moins une couche de silicium, de germanium ou de SiGe.

2. Procédé selon la revendication 1, **caractérisé en ce que** au moins une couche de Si, SiGE et/ou Ge est déposée par épitaxie sur une surface cristalline.

3. Procédé selon l'une des revendications précédentes, **caractérisé en ce que** le substrat est un substrat de Si, SiGe ou Ge.

4. Procédé selon l'une des revendications précédentes, **caractérisé en ce que** au moins une des couches suivantes est déposée : des hyperstructures de Si, Ge, SiGe:C, Si/Ge, des hyperstructures de SiGe/SiGe, des tampons de SiGe, SiGe contenant différentes couches avec Si₁₋ₓGeₓ (0 = x = 1).

5. Procédé selon l'une des revendications précédentes, **caractérisé en ce que** les matières de départ sont injectées alternativement ou simultanément.

6. Procédé selon l'une des revendications précédentes, **caractérisé en ce que** les matières de départ apportées sous forme gazeuse sont distribuées par un distributeur de gaz (15) de façon homogène sur la surface occupée par les substrats.

7. Procédé selon l'une des revendications précédentes, **caractérisé en ce que** le substrat ou les substrats à doter d'un revêtement sont mis en rotation pendant le processus de dépôt.

8. Procédé selon l'une des revendications précédentes, **caractérisé en ce que** au moins une des couches déposées est déformée ou non déformée.

9. Procédé selon l'une des revendications précédentes, **caractérisé en ce que** la composition chimique de la couche est modifiée dans une relation spatiale.

10. Procédé selon l'une des revendications précédentes, **caractérisé par** au moins deux unités d'injection réglables indépendamment et destinées à amener en parallèle les matières de départ pour déposer des couches de types différents.

11. Procédé selon l'une des revendications précédentes, **caractérisé en ce que** les composants, contenant des flux massiques de germanium et de silicium moyennés dans le temps sur plusieurs impulsions, sont modifiés dans la chambre de réaction de façon continue ou discontinue de sorte que le rapport des masses de silicium et de germanium varie dans le sens de la hauteur dans la couche déposée sur le substrat.
